# EUROPEAN PATENT APPLICATION

(11) **EP 4 687 382 A1**
(43) Date of publication of application: **04.02.2026**
(21) Application number: 24306318.7
(22) Date of filing: 02.08.2024
(51) Int. Cl.: H05K 7/20, F28F 13/10, G06F 1/20

(54) **LIQUID COOLING ARRANGEMENT FOR DATACENTER SERVER RACK**

(71) Applicant: OVH, 59100 Roubaix (FR)
(72) Inventor: CHEHADE, Ali, 59283 Moncheaux (FR); KLABA, Miroslaw Piotr, 59100 Roubaix (FR); HNAYNO, Mohamad, 59100 Roubaix (FR)
(74) Representative: BCF Global

(57) **Abstract**

The invention relates to a liquid cooling arrangement for cooling heat-generating components of a datacenter server rack, comprising:
a liquid cooling loop, a plurality of server clusters;
at least one heat exchanger fluidly connected to the liquid cooling units of the plurality of server clusters via the liquid cooling loop, the heat exchanger comprising at least one manifold **(203, 204)** for collecting the cooling liquid and a zone, called thermal exchanges zone, the heat exchanger being configured such that thermal energy is exchanged between the liquid and an air flow in the thermal exchanges zone; and
a pump fluidly coupled to the heat exchanger,
wherein the liquid cooling arrangement **(100)** comprises at least one element **(200)**, called vibrations element, configured to generate a field of vibrations of the cooling liquid in an area of said at least one exchanger, called vibrations area.

## Description

### FIELD OF TECHNOLOGY

The present technology relates to datacenter server rack configurations. A liquid cooling arrangement for cooling heat-generating components of a datacenter server rack

### BACKGROUND

Datacenters are configured to house multitudes of server racks containing electronic equipment, such as computer systems (e.g., server assemblies), memory banks, etc. in efforts to process vast amounts of data in near real time. During operations, the electronic equipment of the server racks generates a significant amount of heat that must be dissipated in order to ensure continued efficient operation of the electronic equipment. Many cooling solutions have been implemented to address this heating issue, including the liquid cooling of heat-generating components by way of liquid cooling blocks directly mounted onto certain heat-generating components (often referred to as liquid or water block units).

Although water block units are capable of efficiently cooling the heat-generating components, their implementation in server racks typically requires a liquid distribution infrastructure to service the multitude of server racks and the vast number of electronic equipment supported therein. Such liquid distribution infrastructures conventionally require the use of relatively large and/or heavy piping conduit configurations and large capacity pumps to maintain the necessary liquid flow rates that supply the water blocks to service the cooling needs of the vast number of corresponding heat-generating components. It will be appreciated that the use of such piping conduit configurations and large pumps can be prohibitively costly for datacenters, in terms of initial investments and operating costs. Such piping conduit configurations and large pumps inherently occupy large footprints which may reduce a productivity (*e.g*. server per unit area of datacenter floor surface).

As a result, it appears to be desirable to provide a liquid cooling arrangement for datacenter server racks that can alleviate at least some of the cost prohibitive issues regarding conventional piping conduit configurations.

It is to be noted that the subject matter discussed in the background section should not be assumed to be prior art merely as a result of its mention in the background section. Similarly, the issues mentioned in the background section should not be interpreted as having been recognized in the prior art.

### SUMMARY

It is an object of the present technology to alleviate at least some of the cost prohibitive issues that prevail in the prior art.

According to one aspect of the present technology, there is provided a liquid cooling arrangement for cooling heat-generating components of a datacenter server rack, comprising:
a liquid cooling loop configured to convey a cooling liquid;
a plurality of server clusters, each server cluster including a plurality of server assemblies that incorporate at least one respective liquid cooling unit configured to collect at least a portion of a thermal energy generated by a heat-generating component of the server assembly;
at least one heat exchanger fluidly connected to the liquid cooling units of the plurality of server clusters via the liquid cooling loop, the heat exchanger comprising at least one manifold for collecting the cooling liquid and a zone, called thermal exchanges zone, the heat exchanger being configured such that thermal energy is exchanged between the liquid and an air flow in the thermal exchanges zone; and
a pump fluidly coupled to the heat exchanger via the liquid cooling loop, the pump configured to convey the cooling liquid in the liquid cooling loop,
wherein the liquid cooling arrangement comprises at least one element, called vibrations element, configured to generating a field of vibrations of the cooling liquid in an area of said at least one exchanger, called vibrations area.

Thanks to the vibrations element(s), the flow of the cooling liquid is locally changed, which helps a reduction of the boundary layer and/or increases local turbulences in the liquid flow, and, consequently, enhances the thermal exchanges between the cooling liquid and the air, thus optimizing the efficiency of the heat exchanger.

In some embodiments, the vibrations area is in the manifold of the heat exchanger and/or the thermal exchanges zone.

In some embodiments, the vibrations element is configured such that the field generated by the vibrations element presents a principal direction forming an angle between 0° to 90° with a local flowing of the liquid in the vibrations area.

In some embodiments, the arrangement comprises at least a first vibrations element and a second vibrations element configured such that a frequency of the first vibrations element is different from a frequency of the second vibrations element.

In some embodiments, the arrangement comprises at least a first vibrations element and a second vibrations element configured such that the field generated by the first vibrations element presents a principal direction forming a non-zero angle with a principal direction of field generated by the second vibrations element.

In some embodiments, the principal direction of the field generated by the first vibrations element is perpendicular to the principal direction of the field generated by the second vibrations element.

In some embodiments, a frequency of the vibrations element is comprised between 30 Hz and 500 Hz, advantageously 150 Hz to 300Hz, and/or 20 kHz and 50 kHz, advantageously 25 kHz, and/or between 0.8 MHz and 1.2 MHz, advantageously 1 MHz, and/or between 1.3 MHz and 1.7 MHz, advantageously 1.5 MHz, and/or between 1.8 MHz and 2.2 MHz, advantageously 2 MHz.

In some embodiments, the vibrations element is an acoustic waves generator.

In some embodiments, the vibrations element is an ultrasonic waves generator.

In some embodiments, the acoustic power of the acoustic waves generator is comprised between 50 W and 200 W, advantageously 100 W.

In some embodiments, the vibrations element comprises an electric motor and a device for shaking the heat exchanger that is controlled by said electric motor.

In some embodiments, the mechanical device comprises a vibrating table fixed to the heat exchanger and/or a shaft fixed to the heat exchanger.

In some embodiments, said at least one exchanger is disposed on a rear door of a rack hosting the server clusters.

In some embodiments, the thermal exchanges zone has a thickness less than 2.1 cm, advantageously less than 1.1 cm, preferably between 2 mm and 1 cm.

In some embodiments, said at least one exchanger is configured to cool the air flow with the cooling liquid circulating in the thermal exchanges zone.

Implementations of the present technology each have at least one of the above-mentioned objects and/or aspects, but may not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
FIG. 1 depicts a functional block diagram of a serialized liquid cooling arrangement for a datacenter server rack, in accordance with some non-limiting embodiments of the present disclosure;
FIG. 2 depicts a heat exchanger of FIG. 1 equipped with several vibrations elements, in accordance with some non-limiting embodiments of the present disclosure;
FIG. 3 depicts specific configuration of a vibrations element, in accordance with some non-limiting embodiments of the present disclosure;
FIG. 4 depicts another specific configuration of a vibrations element, in accordance with some non-limiting embodiments of the present disclosure;
FIG. 5 depicts a specific combination of two vibrations elements, in accordance with some non-limiting embodiments of the present disclosure; and
FIG. 6 depicts another combination of two vibrations elements, in accordance with some non-limiting embodiments of the present disclosure.
FIG. 7 depicts a heat exchanger of FIG. 1 equipped with a vibrations elements, in accordance with some non-limiting embodiments of the present disclosure;

### DETAILED DESCRIPTION

The instant disclosure is directed to addressing at least some of the issues associated with conventional large/heavy piping conduit configurations that supply the liquid flows to the water blocks to adequately service the cooling needs of the vast number of corresponding heat-generating components. In particular, the instant disclosure presents various embodiments of vibrations element that optimize the cooling of heat generating electronic components.

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative systems embodying the principles of the present technology.

With these fundamentals in place, we will now consider some non-limiting examples to illustrate the implementations of the various inventive aspects of the present disclosure.

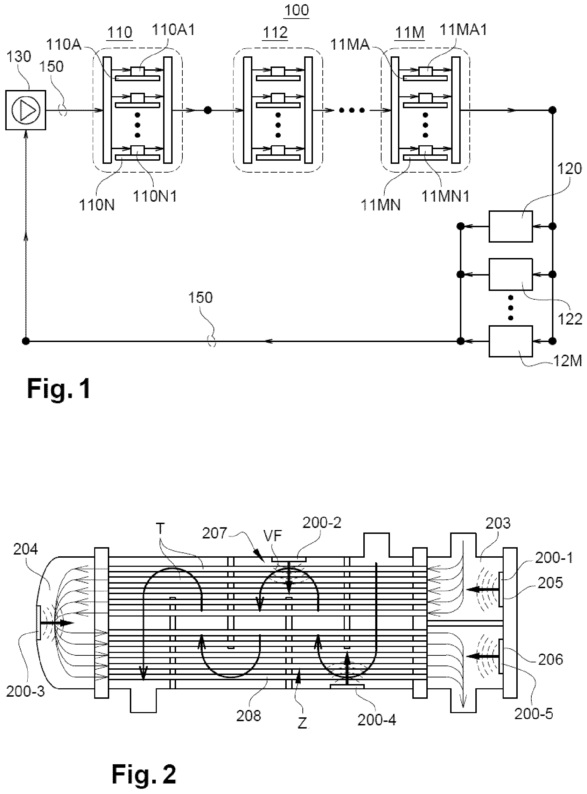

In particular, FIG. 1 depicts a functional block diagram of a server rack serialized liquid cooling arrangement **100,** in accordance with the embodiments of the present disclosure. As shown, liquid cooling arrangement **100** includes a plurality of server clusters **110, 112** ... **11M** that are fluidly connected in series to each other via a server rack liquid cooling loop **150.** The server rack liquid cooling loop **150** is configured to convey and facilitate the flow of a cooling liquid throughout the electronic equipment of the server rack and may be constructed from flexible materials (*e.g*., rubber, plastic, *etc*.), rigid materials (*e.g*., metal, PVC piping, *etc*.), or any combination of thereof. It will be appreciated that the conveyed liquid may include water, alcohol, or any suitable liquid capable of sustaining adequate cooling temperatures.

Each of the server clusters **110, 112 ... 11M** includes a plurality of server assemblies **110A-110N, 112A-112N** ... **11MA-11MN** that are arranged in a parallel and/or serialized manner. As noted above, the server assemblies **110A-110N, 112A-112N** ... **11MA-11MN** contain heat generating electronic components.

Accordingly, each of the parallel server assemblies **110A-110N, 112A-112N** ... **11MA-11MN** incorporates at least one respective liquid cooling unit **110A1-110N1, 112A1-112N1** ... **11MA1-11MN1,** correspondingly arranged in parallel, for the direct thermal contact liquid cooling of the heat generating electronic components. That is, each of the liquid cooling units **110A1-110N1, 112A1-112N1** ... **11MA1-11MN1** is configured as liquid-cooled heat sink conduit block that is thermally coupled, either directly or indirectly, to the heat-generating electronic components, such that cooling liquid is circulated through internal liquid conduits of the liquid cooling units **110A1-110N1, 112A1-112N1** ... **11MA1-11MN1** to absorb the heat from the heat-generating electronic components and discharge the heated liquid therefrom.

For example, each one of the server clusters **110, 112 ... 11M** may include a first manifold that, in use, receives the cooling liquid and feeds the cooling liquid to the plurality of liquid cooling units of the server cluster in parallel. A second manifold may be provided downstream said plurality of liquid cooling units to receive the cooling liquid from the plurality of liquid cooling units.

The liquid cooling arrangement **100** further includes at least one air-to-liquid heat exchangers (ALHEXs), three on FIG. 1, 120, 122 ... 12M.

On FIG. 1, each of the air-to-liquid heat exchangers (ALHEXs) **120, 122 ... 12M** defines an exchanger internal fluid conduit that forms a part of the cooling loop **150.** Therefore, each of the air-to-liquid heat exchangers (ALHEXs) **120, 122 ... 12M** has an inlet through which, in use, the cooling liquid flows into the exchanger internal fluid conduit, and an outlet through which, in use, the cooling liquid is discharged from the exchanger internal fluid.

On FIG. 1, the ALHEXs **120, 122 ... 12M** of the liquid cooling arrangement **100** are fluidly connected in parallel with one another. Namely, the internal fluid conduits of the air-to-liquid heat exchangers (ALHEXs) **120, 122 ... 12M** of the liquid cooling arrangement **100** are fluidly connected in parallel. The ALHEXs **120, 122 ... 12M** of the liquid cooling arrangement **100** are also fluidly coupled to server clusters **110, 112 ... 11M** via the liquid cooling loop **150.** The ALHEXs **120, 122 ... 12M** function to sufficiently air cool the heated liquid received by the liquid cooling units **110A1-110N1, 112A1-112N1** ... **11MA1-11MN1** for redirection back to the server clusters **110, 112 ... 11M.** The ALHEXs **120, 122 ... 12M** may embody any suitable configuration that reduces liquid temperatures through supplied air flow, such as, internal cooling coils, heat extracting air flow fins, *etc.* The ALHEXs **120, 122 ... 12M** may be, for example and without limitations, disposed on rear doors of a rack hosting the server clusters **110, 112 ... 11M.**

The liquid cooling arrangement **100** additionally includes at least one pump **130** that is fluidly connected to the server rack liquid cooling loop **150.** The pump **130** is configured to receive the cooling liquid from the ALHEXs **120, 122** ... **12M,** via the server rack liquid cooling loop **150,** and functions to forcibly provide the necessary circulatory flow rate of the cooling liquid through the server rack liquid cooling loop **150,** in order to service the liquid cooling units **110A1-110N1, 112A1-112N1** ... **11MA1-11MN1** of server clusters **110, 112 ... 11M.**

The present disclosure is not limited to the configuration of FIG. 1. For instance, the heat exchangers ALHEX **120, 122 ... 12M** can be dedicated each to a respective server cluster rather than being in parallel one with another, and/or some of the server clusters can be serialized while others can be connected in parallel one with another.

Also, it should be noted that the ALHEX **120, 122 ... 12M** can have other roles in the loop 150. On FIG. 1, the liquid is cooled in the ALHEX **120, 122 ... 12M** by an air flow. However, the present disclosure also encompasses embodiments wherein the cooling liquid flowing inside the ALHEX **120, 122 ... 12M** can be used to cool an air flow of the rack.

The liquid cooling arrangement **100** comprises at least one element **200,** called vibrations element, for generating a field of mechanical vibrations of the cooling liquid in the ALHEX **120, 122 ... 12M,** as will now be detailed.

According to an embodiment of the present disclosure, the vibrations element **200** is an acoustic waves generator, and/or an ultrasonic waves generator, like an ultrasonic transducer.

According to another embodiment of the present disclosure, the vibrations element **200** is a system comprising an electric motor **201** and a device **202** for inducing a movement to the heat exchanger ALHEX **120, 122 ... 12M** that is coupled with the electric motor **201.**

The present disclosure encompasses ALHEX **120, 122 ... 12M** equipped with only one vibrations element **200,** or several vibrations elements **200.** The vibrations elements **200** can be identical or on the contrary of different types, depending on the level of impact to induce to the flowing of the cooling liquid.

FIG. 2 is now detailed. As can be seen from this figure, the ALHEX comprises a first manifold **203** and a second manifold **204.** The first manifold **203** comprises an inlet plenum **205** for the liquid to enter in the ALHEX and an outlet plenum **206** to let the liquid egress out of the ALHEX. The heat exchanger ALHLEX comprises a first section **207** of tubes **T** to fluidly connect the inlet plenum **205** to the second manifold **204** and a second section **208** of tubes **T** to fluidly connect the second manifold **204** to the outlet plenum **206** of the first manifold **203.** On FIG. 2, the tubes **T** are straight and parallel. The flowing of the liquid inside the ALHEX describes a U-shape.

When the ALHEX is in use, an air flow circulates through the tubes **T** that form a thermal exchanges zone **Z** between the air flow and the cooling liquid flow.

It should be noted that the present disclosure is not limited to a U-shape ALHEX, nor to tubes-ALHEX. On the contrary, the present disclosure encompasses any kind of appropriate shapes for the thermal exchanges zone Z (like I-ALHEX or plate-ALHEX).

As can be seen from FIG. 2, the ALHEX is equipped with five vibrations elements **200-1** to **200-5.** Each vibrations element **200** is configured to generate a vibrational field VF at a given frequency f that induces local modifications of the flowing of the liquid cooling, as will be detailed later. Each vibrational field VF presents a principal direction, corresponding to the main direction of the propagation of the vibrations that are generated by the vibrations element **200.** The principal direction is illustrated by an arrow on the figures. The area where the vibrations are created in the cooling liquid flow is called vibrations area.

The vibrations elements **200** can be located either inside the heat exchanger ALHEX or outside of it, but in any case, each vibrations element **200** is located such that the vibrational field VF has an impact on the cooling liquid.

On FIG. 2, the first vibrations element **200-1** is located such that its vibrational field VF is generated in the inlet plenum **205.** The second vibrations element **200-2** is located such that its vibrational field VF is generated in the first section **207.** The third vibrations element **200-3** is located such that its vibrational field VF is generated in the second manifold **204.** The fourth vibrations element **200-4** is located such that its vibrational field VF is generated in the second section **208.** The fifth vibrations element **200-5** is located such that its vibrational field VF is generated in the outlet plenum **206.**

The present disclosure is not limited to the configuration of FIG. 2. The heat exchanger ALHEX can be equipped with less than five vibrations elements **200,** or on the contrary with more vibrations elements **200.** Also, the heat exchanger ALHEX can be equipped with more than one vibrations elements dedicated to the first section **207** and/or the second section **208.** Furthermore, on FIG. 2, all the principal directions are in the same plane, but the present disclosure also encompasses configuration wherein the principal directions do not all belong to a same plane.

It should be noted that the frequencies of the vibrations element **200** can be comprised between 10 Hz to 5 Mz, like between 30 Hz and 500 Hz, advantageously 100 Hz to 300Hz, advantageously 150 Hz to 300 Hz, advantageously 50 Hz to 200 Hz, and/or 20 kHz and 50 kHz, advantageously 25 kHz, and/or between 0.8 MHz and 1.2 MHz, advantageously 1 MHz, and/or between 1.3 MHz and 1.7 MHz, advantageously 1.5 MHz, and/or between 1.8 MHz and 2.2 MHz, advantageously 2 MHz, between 1.7 MHz to 2.5 MHz.

The present disclosure is now detailed in relationship with the first embodiment.

According to the first embodiment, the vibrations element 200 are acoustic waves generators, advantageously in an audible spectrum, preferably in an ultrasonic spectrum. The disclosure is now detailed with ultrasonic transducers but a similar description applies to any acoustic waves generator.

As is known, ultrasound is sound with frequencies from 20 kHz up to several gigahertz. When the frequency of the ultrasonic transducer **200** is comprised between 20 kHz and 50 kHz, advantageously 25 kHz, cavitation is generated, which can reduce the thickness of the boundary layer, hence enhancing thermal exchanges in the heat exchanger between the air flow and the cooling liquid. When the frequency of the ultrasonic transducer **200** is comprised between 1.8 MHz and 2.2 MHz, advantageously 2 MHz, an acoustic flow is generated, which increases local turbulences of the cooling liquid flow, hence enhancing thermal exchanges in the heat exchanger between the air flow and the cooling liquid. When the frequency of the ultrasonic transducer 200 is comprised between 800 kHz and 1.8 MHz, advantageously 800 kHz to 1.2 MHz, advantageously 1 MHz, there is a combination of cavitation and acoustic flow that enhances thermal exchanges in the heat exchanger.

It should be noted that the Reynolds number of the cooling liquid can be comprised between 500 to 10 000, advantageously between 500 and 800, advantageously between 900 and 5000. The ultrasound transducer **200** has less impact on the cooling liquid flow when the Reynolds number is higher, such that the liquid cooling arrangement is preferred with a Reynolds number between 500 and 800.

The ultrasonic power of the ultrasonic transducer **200** is comprised between 50 W and 200 W, advantageously 100 W.

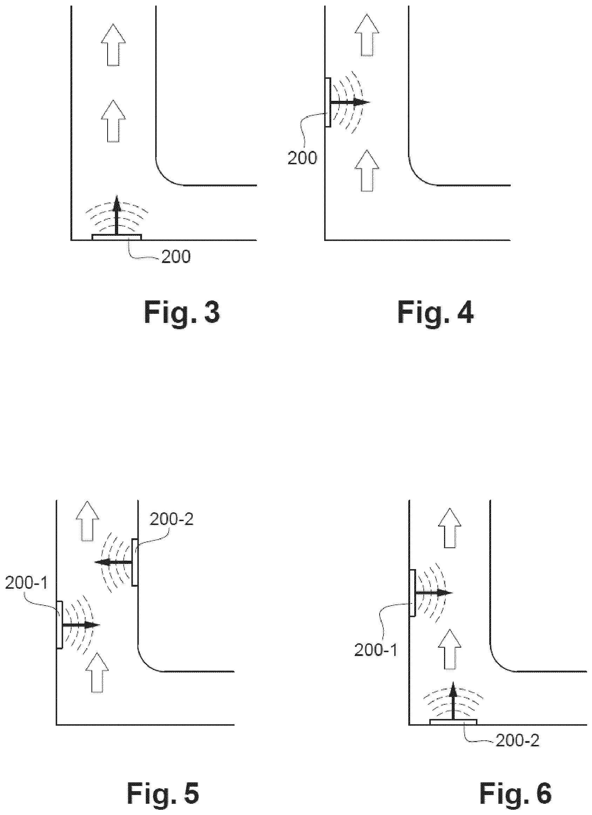

As can be seen from FIG. 3 to FIG. 5, the positioning of the ultrasonic transducer **200** is such that the principal direction of the field VF forms an angle with the local direction of the liquid flow hat is comprised between 0° and 90°. It can be either colinear with the local flow of the cooling liquid (FIG. 3), perpendicular to it (FIG. 4) or forms an acute angle (not illustrated).

As can be seen from FIG. 5 and FIG. 6, two ultrasonic transducers can be positioned such that the principal direction of the field of the first transducer **200-1** forms an angle with the principal direction of the field of the second transducer **200-2** that is comprised between 0° and 90°. The two ultrasonic transducers can be either colinear (FIG. 5) or perpendicular (FIG. 6) or form an acute angle (non illustrated), depending on the level of impact on the cooling liquid.

The two ultrasonic transducers **200-1, 200-2** can be of the same frequencies and ultrasonic power, or, on the contrary of different frequencies and/or ultrasonic power. For instance, the heat exchanger ALHEX can comprise a first ultrasonic transducer of a frequency lower than 1MHz, lower than 500kHz, lower than 100Kz and a second ultrasonic transducer of a frequency comprised between to 1MHz and 1.5 MHz, or between 1.8 MHz and 2.5 MHz. The combination of such two transducer **200-1, 200-2** is of particular interest as illustrated in FIG. 6 wherein the first transducer **200-1** is perpendicular to the flow and has a frequency around 25 kHz while the second transducer **200-2** is colinear with the flow and has a frequency around 1 MHz or 2 MHz.

The present disclosure is now described in relationship with the second embodiment.

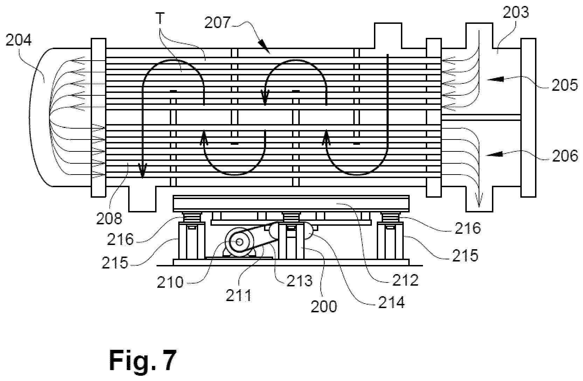

As can be seen from FIG. 7, the vibrations element **200** comprises an electric motor **210** and a device **211** for transmitting vibrations to the heat exchanger that is controlled by the electric motor **210.** The vibrations element **200** also comprises a table **212** supporting the heat exchanger that is set in motion by the device **211.** The device **211** comprises a belt **213** coupled with the electric motor **210** and an eccentric, like an unbalanced element **214.** The vibrations element **200** also comprises legs **215** with suspensions **216.** The device **211** can induce movement either on one axis, two axis or three axis.

The present disclosure is not limited to this configuration and the device **211** can comprise any kind of shaft and/or actuator controlled by the electric motor and adapted to set the heat exchanger in motion.

The frequency of the vibrations element 200 is comprised between 10 Hz and 200 Hz, advantageously 50 Hz or 100 Hz.

As already described for the first embodiment, the positioning of the vibrations element **200** is such that the principal direction of the field VF forms an angle with the local direction of the liquid flow that is comprised between 0° and 90°. It can be either colinear with the local flow of the cooling liquid, perpendicular to it or forms an acute angle.

The liquid cooling arrangement 100 may comprise several vibrations elements **200.**

Two vibrations element **200** can be positioned such that the principal direction of the field of the first transducer **200-1** forms an angle with the principal direction of the field of the second transducer **200-2** that is comprised between 0° and 90°. They can be either colinear or perpendicular or form an acute angle.

Two vibrations element **200** can be of the same frequencies and ultrasonic power, or, on the contrary of different frequencies and/or ultrasonic power. For instance, the heat exchanger ALHEX can comprise a first vibrations element of a frequency lower than 50 Hz, and a second vibrations element of a frequency higher than 50 Hz.

As shown previously, when equipped with the vibrations elements **200,** the heat exchangers ALHEX improve their efficiency because of the optimization of the thermal exchanges between the cooling liquid and the air flow (because of a reduction of the boundary layer and/or current flow, for instance). Having several vibrations elements improves the thermal exchanges even better thanks to a synergy that can appear when the vibrations elements have different frequencies and/or positionings relative to the local liquid flow direction. Another advantage is that the ALHEX can be chosen more compact given the optimized thermal exchanges.

For instance, the heat exchangers ALHEX are configured such that the thermal exchanges zone has a thickness less than 2.1 cm, advantageously less than 1.1 cm, preferably between 2 mm and 1 cm.

Preferably, the heat exchangers are disposed at the rear door of the on rear doors of a rack hosting the server clusters **110, 112 ... 11M,** as already explained.

The present disclosure is of particular interest wherein the cooling liquid flowing inside the ALHEX **120, 122 ... 12M** can be used to cool an air flow of the rack.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A liquid cooling arrangement for cooling heat-generating components of a datacenter server rack, comprising:
a liquid cooling loop configured to convey a cooling liquid;
a plurality of server clusters, each server cluster including a plurality of server assemblies that incorporate at least one respective liquid cooling unit configured to collect at least a portion of a thermal energy generated by a heat-generating component of the server assembly;
at least one heat exchanger fluidly connected to the liquid cooling units of the plurality of server clusters via the liquid cooling loop, the heat exchanger comprising at least one manifold (**203, 204**) for collecting the cooling liquid and a zone, called thermal exchanges zone, the heat exchanger being configured such that thermal energy is exchanged between the liquid and an air flow in the thermal exchanges zone; and
a pump (**130**) fluidly coupled to the heat exchanger via the liquid cooling loop, the pump configured to convey the cooling liquid in the liquid cooling loop,
wherein the liquid cooling arrangement (**100**) comprises at least one element (**200**), called vibrations element, configured to generate a field of vibrations of the cooling liquid in an area of said at least one exchanger, called vibrations area.

2. A liquid cooling arrangement of claim 1, wherein the vibrations area is in the manifold (**203, 204**) of the heat exchanger and/or the thermal exchanges zone (**207, 208**).

3. A liquid cooling arrangement of claim 1 or 2, wherein the vibrations element (**200**) is configured such that the field generated presents a principal direction forming an angle between 0° to 90° with a local flowing of the liquid in the vibrations area.

4. A liquid cooling arrangement of any of the preceding claims, comprising at least a first vibrations element (**200-1**) and a second vibrations element (**200-2**) configured such that a frequency of the first vibrations element (**200-1**) is different from a frequency of the second vibrations element (**200-2**).

5. A liquid cooling arrangement of any of the preceding claims, comprising at least a first vibrations element (**200-1**) and a second vibrations element (**200-2**) configured such that the field generated by the first vibrations element (**200-1**) presents a principal direction forming a non-zero angle with a principal direction of the field generated by the second vibrations element (**200-2**).

6. A liquid cooling arrangement of the preceding claim, wherein the principal direction of the field generated by the first vibrations element (**200-1**) is perpendicular to the principal direction of the field generated by the second vibrations element (**200-2**).

7. A liquid cooling arrangement of any of the preceding claims, wherein a frequency of the vibrations element (**200**) is comprised between 30 Hz and 500 Hz, advantageously 150 Hz to 300Hz, and/or 20 kHz and 50 kHz, advantageously 25 kHz, and/or between 0.8 MHz and 1.2 MHz, advantageously 1 MHz, and/or between 1.3 MHz and 1.7 MHz, advantageously 1.5 MHz, and/or between 1.8 MHz and 2.2 MHz, advantageously 2 MHz.

8. A liquid cooling arrangement of any of the preceding claims, wherein the vibrations (**200**) is an acoustic waves generator.

9. A liquid cooling arrangement of any of the preceding claim, wherein the vibrations element (**200**) is an ultrasonic waves generator.

10. A liquid cooling arrangement of claim 8 or 9, wherein the acoustic power of the acoustic waves generator is comprised between 50 W and 200 W, advantageously 100 W.

11. A liquid cooling arrangement of any of the preceding claims, wherein the vibrations element (**200**) comprises an electric motor (**210**) and a device (**211**) for shaking the heat exchanger that is controlled by said electric motor (**210**).

12. A liquid cooling arrangement of the preceding claim, wherein the mechanical device (**211**) comprises a vibrating table (**212**) fixed to the heat exchanger and/or a shaft fixed to the heat exchanger.

13. A liquid cooling arrangement of any of the preceding claims, wherein said at least one exchanger (**120, 122 ... 12M**) is disposed on a rear door of a rack hosting the server clusters (**110, 112 ... 11M**).

14. A liquid cooling arrangement of any of the preceding claims, wherein the thermal exchanges zone has a thickness less than 2.1 cm, advantageously less than 1.1 cm, preferably between 2 mm and 1 cm.

15. A liquid cooling arrangement of any of the preceding claims, wherein said at least one exchanger is configured to cool the air flow with the cooling liquid circulating in the thermal exchanges zone.

## Amended claims

### Amended claims in accordance with Rule 137(2) EPC.

1. A liquid cooling arrangement for cooling heat-generating components of a datacenter server rack, comprising:
a liquid cooling loop configured to convey a cooling liquid;
a plurality of server clusters, each server cluster including a plurality of server assemblies that incorporate at least one respective liquid cooling unit configured to collect at least a portion of a thermal energy generated by a heat-generating component of the server assembly;
at least one heat exchanger fluidly connected to the liquid cooling units of the plurality of server clusters via the liquid cooling loop, the heat exchanger comprising at least one manifold (**203, 204**) for collecting the cooling liquid and a zone, called thermal exchanges zone, the heat exchanger being configured such that thermal energy is exchanged between the liquid and an air flow in the thermal exchanges zone; and
a pump (**130**) fluidly coupled to the heat exchanger via the liquid cooling loop, the pump configured to convey the cooling liquid in the liquid cooling loop,
wherein the liquid cooling arrangement (**100**) comprises at least one element (**200**), called vibrations element, configured to generate a field of vibrations of the cooling liquid in an area of said at least one exchanger, called vibrations area, wherein the vibrations element (**200**) is an ultrasonic waves generator.

2. A liquid cooling arrangement of claim 1, wherein the vibrations area is in the manifold (**203, 204**) of the heat exchanger and/or the thermal exchanges zone (**207, 208**).

3. A liquid cooling arrangement of claim 1 or 2, wherein the vibrations element (**200**) is configured such that the field generated presents a principal direction forming an angle between 0° to 90° with a local flowing of the liquid in the vibrations area.

4. A liquid cooling arrangement of any of the preceding claims, comprising at least a first vibrations element (**200-1**) and a second vibrations element (**200-2**) configured such that a frequency of the first vibrations element (**200-1**) is different from a frequency of the second vibrations element (**200-2**).

5. A liquid cooling arrangement of any of the preceding claims, comprising at least a first vibrations element (**200-1**) and a second vibrations element (**200-2**) configured such that the field generated by the first vibrations element (**200-1**) presents a principal direction forming a non-zero angle with a principal direction of the field generated by the second vibrations element (**200-2**).

6. A liquid cooling arrangement of the preceding claim, wherein the principal direction of the field generated by the first vibrations element (**200-1**) is perpendicular to the principal direction of the field generated by the second vibrations element (**200-2**).

7. A liquid cooling arrangement of any of the preceding claims, wherein a frequency of the vibrations element (**200**) is comprised between 20 kHz and 50 kHz, advantageously 25 kHz, and/or between 0.8 MHz and 1.2 MHz, advantageously 1 MHz, and/or between 1.3 MHz and 1.7 MHz, advantageously 1.5 MHz, and/or between 1.8 MHz and 2.2 MHz, advantageously 2 MHz.

8. A liquid cooling arrangement of any of the preceding claims, wherein the acoustic power of the acoustic waves generator is comprised between 50 W and 200 W, advantageously 100 W.

9. A liquid cooling arrangement for cooling heat-generating components of a datacenter server rack, comprising:
a liquid cooling loop configured to convey a cooling liquid;
a plurality of server clusters, each server cluster including a plurality of server assemblies that incorporate at least one respective liquid cooling unit configured to collect at least a portion of a thermal energy generated by a heat-generating component of the server assembly;
at least one heat exchanger fluidly connected to the liquid cooling units of the plurality of server clusters via the liquid cooling loop, the heat exchanger comprising at least one manifold (**203, 204**) for collecting the cooling liquid and a zone, called thermal exchanges zone, the heat exchanger being configured such that thermal energy is exchanged between the liquid and an air flow in the thermal exchanges zone; and
a pump (**130**) fluidly coupled to the heat exchanger via the liquid cooling loop, the pump configured to convey the cooling liquid in the liquid cooling loop,
wherein the liquid cooling arrangement (**100**) comprises at least one element (**200**), called vibrations element, configured to generate a field of vibrations of the cooling liquid in an area of said at least one exchanger, called vibrations area,
wherein the vibrations element (**200**) comprises an electric motor (**210**) and a device (**211**) for shaking the heat exchanger that is controlled by said electric motor (**210**).

10. A liquid cooling arrangement of the preceding claim, wherein the mechanical device (**211**) comprises a vibrating table (**212**) fixed to the heat exchanger and/or a shaft fixed to the heat exchanger.

11. A liquid cooling arrangement of any of the preceding claims, wherein a frequency of the vibrations element (**200**) is comprised between 30 Hz and 500 Hz, advantageously between 150 Hz and 300 Hz.

12. A liquid cooling arrangement of any of the preceding claims, wherein said at least one exchanger (**120, 122 ... 12M**) is disposed on a rear door of a rack hosting the server clusters (**110, 112 ... 11M).**

13. A liquid cooling arrangement of any of the preceding claims, wherein the thermal exchanges zone has a thickness less than 2.1 cm, advantageously less than 1.1 cm, preferably between 2 mm and 1 cm.

14. A liquid cooling arrangement of any of the preceding claims, wherein said at least one exchanger is configured to cool the air flow with the cooling liquid circulating in the thermal exchanges zone.
